# EUROPEAN PATENT APPLICATION

(11) **EP 4 542 637 A1**
(43) Date of publication of application: **23.04.2025**
(21) Application number: 23823957.8
(22) Date of filing: 14.06.2023
(51) Int. Cl.: H01L 23/13, H01L 23/12, H01L 23/15, H05K 1/02, H05K 1/03, H05K 3/00

(54) **CERAMIC SUBSTRATE, CERAMIC CIRCUIT SUBSTRATE, SEMICONDUCTOR DEVICE, CERAMIC SUBSTRATE MANUFACTURING METHOD, AND CERAMIC DIVIDED SUBSTRATE MANUFACTURING METHOD**

(30) Priority: 14.06.2022 JP 2022095379
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: MATSUMOTO, Yukihisa, Yokohama-shi, Kanagawa 235-0032 (JP)
(74) Representative: Hoffmann Eitle
(86) International application number: PCT/JP2023/022115
(87) International publication number: WO 2023/243667

(57) **Abstract**

In a ceramic substrate according to an embodiment, there are two or more peaks within a range of 98 eV or higher and 106 eV or lower in a spectrum obtained by measuring a laser-irradiated zone on a laser-processed surface by X-ray Photoelectron Spectroscopy (XPS). A ceramic circuit board and a semiconductor device including the ceramic substrate are provided. Methods for manufacturing the ceramic substrate and a ceramic split substrate are also provided.

## Description

### TECHNICAL FIELD

An embodiment generally relates to a ceramic substrate, a ceramic circuit board, a semiconductor device, a method for manufacturing a ceramic substrate, and a method for manufacturing a ceramic split substrate.

### BACKGROUND ART

Recently, a demand for ceramic substrates having both heat dissipation and electrical insulation has been increasing every year in conjunction with the development of semiconductor elements requiring a large electric current such as power electronics and next-generation power semiconductors. Particularly, an increase in the amount of heat generated from elements along with size reduction and performance improvement creates a tendency that the thicknesses of ceramic substrates become thinner to dissipate heat efficiently.

Incidentally, ceramic substrates are manufactured in larger shapes to reduce the manufacturing cost. Among ceramic substrates, a silicon nitride substrate that has a high strength, high toughness, and high heat dissipation and is 220 mm × 220 mm × 0.32 mm in size has been disclosed (Patent Document 1).

As one of the methods for splitting a silicon nitride substrate, which has been manufactured in a large size as a ceramic substrate to reduce the manufacturing cost, into product sizes to be used, a method in which the silicon nitride substrate is split into multiple pieces using scribe lines formed by laser processing has been disclosed (Patent Document 2). According to Patent Document 2, microcracks are not generated more than necessary in the silicon nitride substrate while the silicon nitride substrate is split into multiple pieces by laser processing, and the scribe line processing for splitting into multiple pieces is also easy and inexpensive.

Incidentally, since the substrate to be split is thin and large, a problem arising from the laser processing performed on the ceramic substrate having high strength and high toughness has been clarified. For example, a large force is required to break the ceramic substrate having high strength along the scribe lines, and thus there is a need to send the laser deep into the ceramic substrate in the thickness direction. However, a large amount of energy is required to form deep scribe lines in the thickness direction like this. When the energy of the laser is converted into the energy of scribing, a part of the energy is converted into heat energy. In a case where the proportion of the energy converted into this heat energy is large, a heat effect becomes large. Therefore, this heat effect often puts a silicon compound into a state where the oxidation thereof has proceeded.

In the conventional measurement of laser-processed surfaces by X-ray Photoelectron Spectroscopy (XPS), there are not always cases where two or more peaks within a range of 528 eV or higher and 536 eV or lower are observed in any places on the processed surface. Therefore, on the processed surface, places easy to split and places hard to split are present in a mixed manner, and there is a problem in that a ceramic substrate is split during transportation or washing in some cases.

### PRIOR ART DOCUMENTS

### PATENT DOCUMENT

Patent Document 1: Japanese Patent No. 6399252
Patent Document 2: Japanese Patent Laid-Open No. 2002-176119

### SUMMARY OF THE INVENTION

### PROBLEMS TO BE SOLVED BY THE INVENTION

Recently, along with an increase in the junction temperatures of power semiconductor chips, there has been a demand for high reliability of ceramic circuit boards. This has created a demand for a high-strength thin ceramic circuit board having heat dissipation and electrical insulation without impairing high reliability.

An embodiment is to solve such a problem and relates to a ceramic substrate having excellent cost performance that enables small substrates to be efficiently manufactured from a high-strength thin and large ceramic substrate having heat dissipation and electrical insulation.

### MEANS FOR SOLVING THE PROBLEMS

In a ceramic substrate according to an embodiment, there are two or more peaks within a range of 98 eV or higher and 106 eV or lower in a spectrum obtained by measuring a laser-irradiated zone on a laser-processed surface by X-ray Photoelectron Spectroscopy (XPS).

### BRIEF DESCRIPTION OF THE DRAWINGS

FIG. 1 is a top view showing one example of a ceramic substrate according to an embodiment.
FIG. 2 is a view schematically showing one example of an XPS measurement result of the ceramic substrate according to the embodiment.
FIG. 3 is a view schematically showing one example of scribe lines in the substrate of FIG. 1 when seen from diagonally above.
FIG. 4 is a top view showing a different example of the ceramic substrate according to the embodiment.
FIG. 5 is a top view showing one example in the case where the ceramic substrate according to the embodiment has a circular shape.
FIG. 6 is a side view showing one example of the ceramic circuit board according to the embodiment.
FIG. 7 is a view showing one example of a laser processing method according to the embodiment.
FIG. 8 is a top view showing a different example of the ceramic substrate according to the embodiment.
FIG. 9 is a top view showing a different example of the ceramic substrate according to the embodiment.
FIG. 10 is a top view showing a different example of the ceramic substrate according to the embodiment.
FIG. 11 is an enlarged top view showing a different example of the ceramic substrate according to the embodiment.
FIG. 12 is a cross-sectional view showing one example of a portion cut at a break line in a ceramic substrate after splitting according to the embodiment.
FIG. 13 is a cross-sectional view showing one example of a portion cut at a break line in a ceramic substrate after splitting according to the embodiment.
FIG. 14 is a view showing one example of a method for manufacturing the ceramic substrate according to the embodiment as a flowchart.
FIG. 15 is a view showing one example of a method for manufacturing the ceramic substrate according to the embodiment as a flowchart.
FIG. 16 is a view showing one example of a method for manufacturing the ceramic substrate according to the embodiment as a flowchart.
FIG. 17 is an enlarged top view showing one example of misalignment of the ceramic substrate according to the embodiment.
FIG. 18 is an enlarged top view showing one example of a defect in the splitting of the ceramic substrate according to the embodiment.
FIG. 19 is a top view showing a different example of the ceramic substrate according to the embodiment.

### DESCRIPTION OF EMBODIMENTS

A scribe line according to an embodiment refers to a scribe line before a ceramic laser-scribed substrate is split into ceramic split substrates and a scribe line mark after the substrate is split into ceramic split substrates (hereinafter, referred to as "scribe line"). In a ceramic substrate having a scribe line according to the embodiment, the scribe line is formed by irradiation with a laser, and in a spectrum obtained by measurement by X-ray Photoelectron Spectroscopy (XPS), two or more peaks are observed within a range of 98 eV or higher and 106 eV or lower. Two or more peaks within the above-described range indicate that more than two peaks, for example, three or four peaks, may be observed. "Splitting" of the ceramic laser-scribed substrate is also referred to as "breaking" of the ceramic laser-scribed substrate.

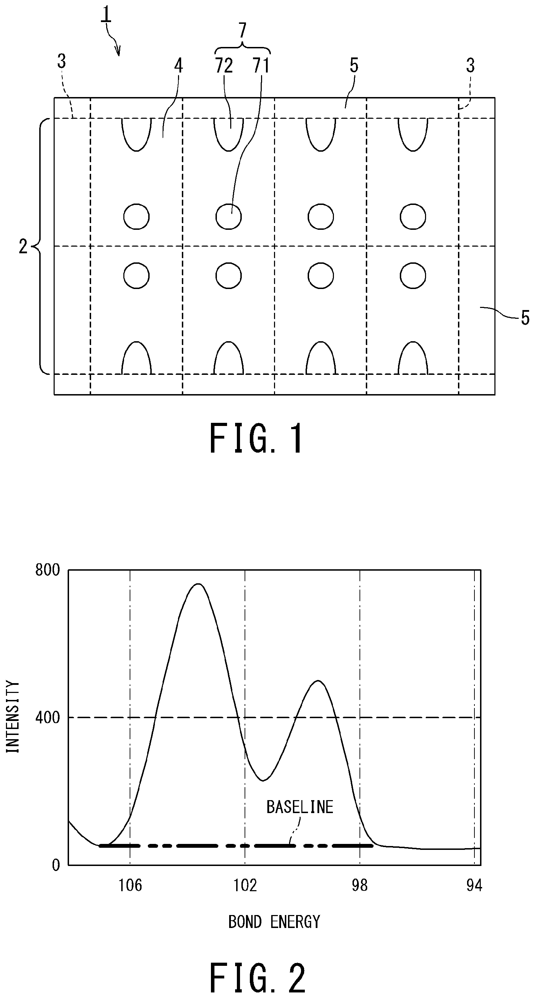

FIG. 1 shows a plan view of one example of a ceramic substrate according to the embodiment. Reference sign 1 is a ceramic laser-scribed substrate, Reference sign 2 is a ceramic multipiece substrate, Reference sign 3 is a scribe line that is a non-penetration hole, Reference sign 4 is each ceramic split substrate, which serves as a product, Reference sign 5 is a peripheral portion, which is not used as a product, Reference Sign 7 is a penetration hole, Reference sign 71 is a through hole, which is one example of the penetration hole 7, and Reference sign 72 is a notch portion, which is another example of the penetration hole 7. The ceramic laser-scribed substrate 1 is roughly composed of the ceramic multipiece substrate 2 and the peripheral portion 5. In the present specification, the ceramic substrate means the ceramic laser-scribed substrate 1, the ceramic multipiece substrate 2, or the ceramic split substrate 4.

In addition, regarding laser processing in the present invention, a shape to be processed does not matter. The shape may be the scribe line 3 as described above, and the laser processing may be the formation of the notch portion 72 suitable for screw fastening or, furthermore, drilling. The notch portion 7 is formed by providing a plurality of dots on a sintered substrate in an overlapping manner with a laser. When two or more peaks are made to be observable within a range of 98 eV or higher and 106 eV or lower as described above in any observation regions, in the case of, for example, a screw fastening portion, uneven strength on the processed surface is reduced, and it is possible to increase the torque. In addition, when a scribe line is formed in the same manner as well, breaking during transportation does not occur, and furthermore, it is also possible to suppress the generation of defects during splitting.

FIG. 1 shows an example in which the ceramic laser-scribed substrate is split into a total of eight ceramic split substrates 4 (two rows of four pieces of ceramic split substrates) by laser scribing.

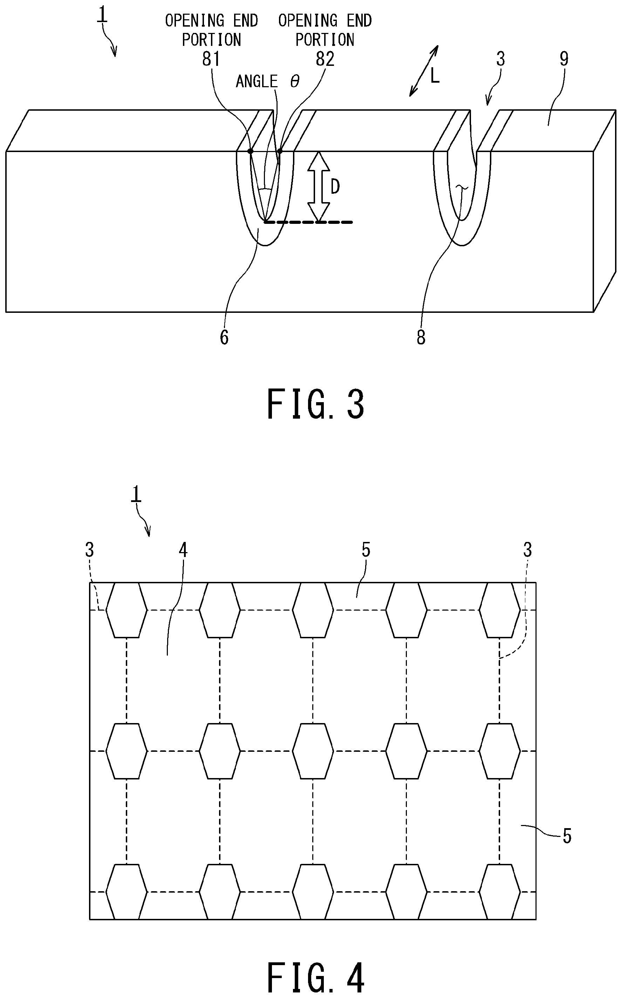

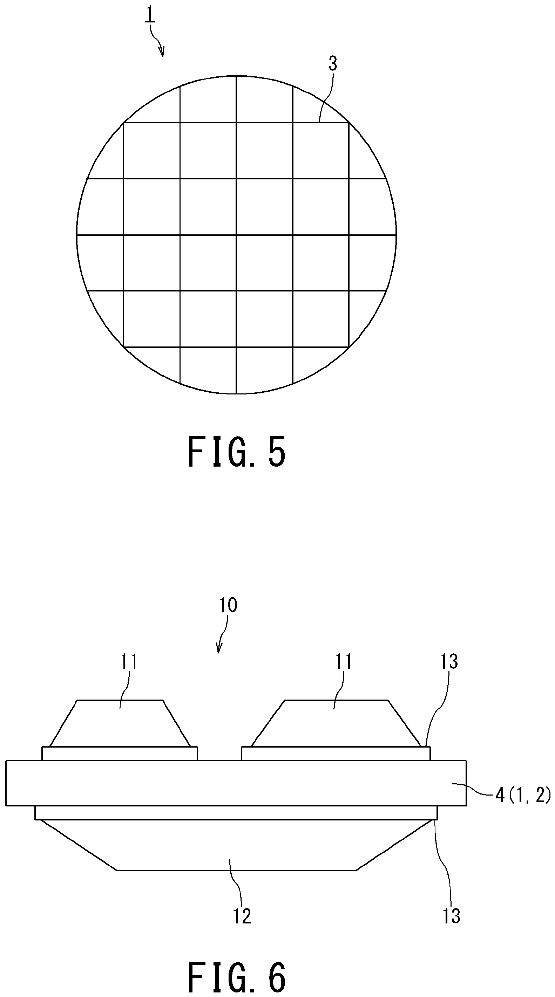

The ceramic laser-scribed substrate 1 is not limited to such a form, one ceramic split substrate 4 may be processed into a product shape using a scribe line 3, or the ceramic laser-scribed substrate may be split into multiple pieces of ceramic split substrates 4 that is more than two rows of four pieces of ceramic split substrates. There is no need to form the scribe lines 3 in all of the four sides of the ceramic split substrate 4, and the scribe line 3 may be formed in one or more places. In addition, in FIG. 1, the ceramic split substrate 4 has a rectangular shape in a plan view, but may have a substantially polygonal shape, may have a substantially circular shape, or may have a substantially polygonal shape with rounded corner portions. In addition, these subscribe lines 3 may be provided on both the front and rear of the ceramic laser-scribed substrate 1. The scribe line 3 may be formed by a combination of the laser and a different method. In the laser processing of the invention, only one oscillation method of either of continuous oscillation or pulse oscillation may be used or both oscillation methods may be used in combination. Furthermore, the shape of the ceramic laser-scribed substrate 1 may be a circular shape as in FIG. 5. In addition, the ceramic laser-scribed substrate 1 may have a shape such as a shape after break having notches at corner portions as in FIG. 4.

In the portions of the ceramic split substrates 4 in the ceramic substrates 1 and 2 and a ceramic circuit board 10 (shown in FIG. 6), two or more peaks are observed within a range of 98 eV or higher and 106 eV or lower in a spectrum obtained by measurement by XPS.

In a case where the ceramic substrates 1, 2 and 4 are silicon nitride substrates, it is possible to provide a high strength such as a three-point bending strength of 600 MPa or higher or, furthermore, 700 MPa or higher. In addition, the thermal conductivity is 50 W/m·K or higher or, furthermore, 80 W/m·K or higher. As a substrate having a thermal conductivity of 80 W/m·K or higher, a substrate having a thermal conductivity of approximately 130 W/m·K is an exemplary example. In a case where the ceramic substrates 1, 2 and 4 are silicon nitride substrates, it is possible to provide a high thermal conductivity such as a thermal conductivity of 170 W/m·K or higher or, furthermore, 230 W/m·K or higher. In addition, there is a substrate having a three-point bending strength of 350 MPa or higher or, furthermore, 450 MPa or higher. In particular, recently, there have been also a silicon nitride substrate and an aluminum nitride substrate which have both high strength and high thermal conductivity.

The ceramic substrates 1, 2 and 4 may be single plates or may have a three-dimensional structure such as a multilayer structure (a structure of ceramic, a conductor portion, ceramic, and a conductor portion). In addition, the ceramic substrates 1, 2 and 4 are preferably Si-containing ceramic substrates. Examples of the Si-containing ceramic substrates include ceramic substrates containing any one or more of sialon, silicon nitride, and silicon carbide as a main component. A silicon nitride substrate is more preferably used as the Si-containing ceramic substrate.

The scribe line 3 is a line processed with a laser. The laser that is used at this time is preferably a laser selected from a semiconductor laser, a fiber laser, an excimer laser, a femtosecond laser, a YAG laser, a YVO laser, a CO₂ laser, a DDL laser, and a blue laser. In addition, in the case of using a YAG laser, a second harmonic, a third harmonic, or a fourth harmonic may be used as necessary. A laser having a wavelength of 1200 nm is more preferably used. Examples of the laser having a wavelength of 1200 nm or shorter as described above include a fiber laser, an excimer laser, a femtosecond laser, a YAG laser, a YVO laser, and the like. Among these lasers, a fiber laser is still more preferably used. At the time of using such a laser, a condensing lens or a mirror may be used as necessary. In the case of using a condensing lens, it is preferable to use the condensing lens under appropriate conditions depending on the position or thickness of the substrate regarding the kind or disposition thereof. When the conditions of the condensing lens are optimized as described above, it is possible to adjust the depth of focus. At the time of forming the scribe line 3 as described above, it is preferable to form a groove shape by moving a substrate that serves as the source of the ceramic laser-scribed substrate 1 (for example, a sintered substrate after a sintering step). As a method for controlling the groove shape by adjusting a laser beam, two methods, such as a method in which the direction is adjusted using a mirror and a method in which the laser itself is adjusted, can be exemplified, but there is a concern that it may not be possible to maintain the position accuracy depending on the distance of the light path or the like in both methods. In addition, since energy to be radiated may vary with the length of the light path, and the laser is a precision machine, when the laser itself is moved many times, there is a concern that the oscillation energy of the laser may change over time. When such a problem is caused, there is a concern that it may not be possible to control a peak that is obtained by XPS.

Therefore, it is preferable to place the sintered substrate itself on a stand (stage) and move the stage itself. In the case of using a mirror, a method in which the mirror is moved may also be used; however, in such a case, there is a concern that the position accuracy may become poorer as the distance from the mirror to a processing object becomes longer. The fiber laser is a laser in accordance with the definition of JIS Z 3001-5 (2013). The fiber laser may be a laser containing Nd, Er, or Ho doped into YAG crystals or a laser in which KLN, PPLN, sapphire, ruby, or the like is used. The fiber diameter is preferably 100 µm or less. Regarding the accuracy of the diameter, the error is preferably 0.001 mm or less, and it is preferable that both the parallelism and the perpendicularity are controlled.

In the above-described lasers, including the fiber laser, a second harmonic, a third harmonic, a fourth harmonic, or the like may be used using a wavelength convertible crystal such as BBO (beta-barium borate). In the case of using the fiber laser, it is more preferable to use either of a step index or a graded index as the index type. In the step index, the refractive index in the core is constant; however, in the graded index, the refractive index in the core is not constant, and the intensity distribution becomes higher in the central portion. Therefore, in the graded index, deep processing is possible with the same output. The oscillation mode may be a single mode or a multimode, but the single mode is more preferably used. Here, a heat-affected zone (HAZ) will be described. This heat-affected zone refers to a zone that spreads out in a substantially concentric shape.

In the formation of the scribe line, an assist gas may be used. As the assist gas that is used at this time, nitrogen or the atmosphere is preferably used. This assist gas is preferably injected from an injection port before a laser beam is oscillated from an irradiation port of the laser. This is because the speed of light is much faster than the speed of sound, in a case where the assist gas is injected at the same time as the oscillation, an air resistance is generated, time is taken for the assist gas to reach the surface of the sintered substrate, a time difference is caused, and there is a concern that the effect of the use of the assist gas may be reduced in such a case.

It is preferable to perform dust collection regardless of the use of the assist gas. Dust collection makes it possible to remove fine high-temperature dust generated by the laser irradiation. Dust collection performed as described above makes it possible to inhibit the generation of bubbles that can be generated when the generated fine dust is re-deposited.

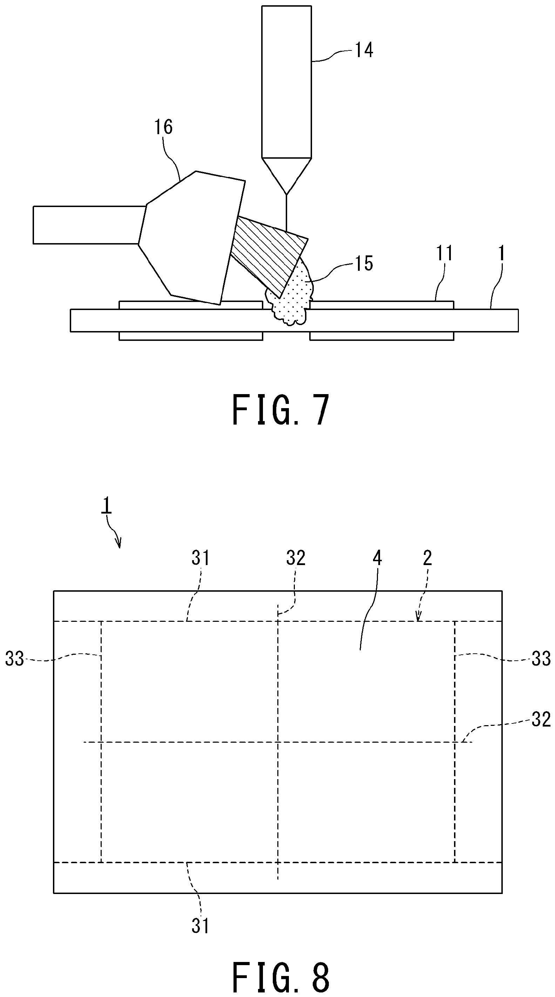

FIG. 7 schematically shows a method for dust collection during the laser processing. Reference sign 1 is the ceramic laser-scribed substrate, Reference sign 11 is a metal circuit, Reference sign 14 is a laser processing machine, Reference sign 15 is fine particles generated by the laser irradiation, and Reference sign 16 is a dust collector. As shown in FIG. 7, dust collection of the fine particles 15 is performed with the dust collector 16 at the same time as a laser beam is radiated to the ceramic laser-scribed substrate 1, on which a metal circuit 11 has been formed, from the laser processing machine 14. This makes it possible to suppress a phenomenon in which the fine particles 15 cover a discharge port of the laser and the output or the like of the laser becomes unstable. When the output of the laser is made to be stable as described above, it is also possible to suppress a change of a laser product over time in a laser-irradiated zone.

The scribe line may be obtained by a plurality of times of laser irradiation in the formation of the scribe line 3. In a case where the scribe line 3 is formed by performing a plurality of times of laser irradiation on the same place, it is preferable to have an interval of one millisecond or longer in the current laser processing until the next laser processing. That is, in a case where the laser processing is performed on the same place, the time interval between, for example, an n-th (n: natural number) irradiation and an (n + 1)-th irradiation is 1 µsec or longer. In addition, a plurality of time intervals that appear as time elapses may be the same as or different from one another. For example, the interval between the n-th irradiation and the (n + 1)-th irradiation and the interval between the (n + 1)-th irradiation and (n + 2)-th irradiation may be different from or the same as each other. The reason for having time intervals in the case of performing irradiation a plurality of times separately is that the next laser irradiation can be performed after heat energy remaining in the sintered substrate by irradiation is reduced. This interval is more preferably three minutes or shorter. This is because, when the interval is longer than three minutes, time is taken for manufacturing, and there is a concern that the yield may deteriorate. The laser oscillation may be any one of a continuous wave (CW) or a pulse wave (PW) or may be a combination of a continuous wave and a pulse wave. In the case of using the pulse wave, the pulse width is more preferably on the order of nanoseconds or shorter. A long pulse width makes the effect of the laser irradiation excessive and makes oxidation progress, which creates a concern that two or more peaks may not be observed within a range of 98 eV or higher and 106 eV or lower.

The ceramic substrates 1, 2 and 4 are suitably Si-containing ceramic substrates, the scribe lines 3 are formed by the laser processing, and in a spectrum obtained by measuring the laser-irradiated zone, which is the laser-processed surface, by XPS, two or more peaks are observed within a range of 98 eV or higher and 106 eV or lower. The upper limit of the number of the peaks is not particularly limited, but is preferably 10 or less, more preferably five or less, and still more preferably three or less. When the peak intensity of the strongest peak within a range of 98 eV or higher and lower than 101 eV is indicated by I2, and the peak intensity of the strongest peak within a range of 101 eV or higher and 106 eV or lower is indicated by I3, I3/I2, which is a ratio between the peak intensities, is 0.4 or more and 12 or less. I3/I2 is preferably 0.6 or more and 4.5 or less. I3/I2 is more preferably 0.9 or more and 4.1 or less. I3/I2 is still more preferably 0.9 or more and 1.7 or less.

Here, the peak intensity will be defined. The peak intensity refers to a value obtained by subtracting the height of the baseline from the height of a peak at that time. The baseline refers to a straight line that connects an end portion and another end portion of the peak as shown in FIG. 2. The end portion of this peak refers to a place where the slope of the spectrum becomes zero for the first time (local minimum value) in one direction from the place where the peak is the strongest. However, in a case where a local minimum value is present between local maximum values and is apart from any of the local maximum values only by a distance that is less than twice the half width, it is preferable to use a separate local minimum value that exceeds the local maximum value. In a case where it is difficult to measure such a local minimum value, the height of one end portion is regarded as the height of the baseline. This I2 indicates the intensity of a peak of Si-Si, and I3 indicates the peak intensity of Si-O. Therefore, the intensity ratio between the peaks of Si-O and Si-Si being adjusted to 2.5 or less means that the oxidation of Si due to the heat effect caused by the laser processing has been reduced.

In order to control the intensity of the peak as described above, it is preferable to perform the laser processing on the sintered substrate while dust collection is performed under an environment where the humidity is 30% or higher and 80% or lower and the temperature is 28 degrees Celsius or lower. The humidity is more preferably 35% or higher and 75% or lower. The laser processing that is performed under an environment where the humidity is lower than 30% is not preferable since there is a concern that static electricity may occur and fine bubbles are likely to be generated due to repulsion between charged fine particles. On the other hand, when the humidity is as high as more than 80%, water molecules in the atmosphere may absorb the energy of the laser and a silicon compound may be hydrated. When a hydrate is formed as described above, there is a concern that the absolute value of the peak of Si-O may become small. This is because the unshared electron pairs of oxygen are used not for bonds with Si but for bonds with hydrogen atoms. In the hydrate generated by the absorption of the energy of the laser, the molecules form a hydrogen bond. The hydrogen bond is a bond having a weaker bond energy than a covalent bond.

Therefore, when a large amount of a hydrate is generated, there is a concern that the intensity on a side surface thereof may decrease. Therefore, the generation of a large amount of a silicon hydrate is not preferable. Here, the humidity refers to the amount of water vapor in the atmosphere relative to the amount of saturated water vapor, and the amount of saturated water vapor increases with an increase in temperature. Therefore, even at the same humidity, as the temperature increases, the number of the water molecules present in the same volume increases. Therefore, when the temperature is higher than 28 degrees Celsius, the amount of saturated water vapor increases, and there is a concern that the effect of the humidity controlled to 80% or lower may not be sufficiently obtained. Therefore, the temperature during the laser processing is preferably 28 degrees Celsius or lower.

The timing of irradiating the substrate that serves as the source of the ceramic laser-scribed substrate 1 with the laser is not particularly limited, but the timing is preferably after sintering. This is because the size of the sintered substrate after sintering changes only to a small extent in the subsequent steps and it is easy to maintain the positions of the scribe lines. A conductor portion may be joined after the formation of the scribe lines on the sintered substrate, or the scribe lines may be formed after the joining of the conductor portion to the sintered substrate. Here, "after the joining of the conductor portion" may be after or before an etching step, and the etching step may not be provided. Examples of a method not provided with the etching step include a method in which a conductor portion that has been already imparted with a circuit shape by punching or the like is joined and the like. The focal distance is preferably 0.5 mm or longer and preferably 30 mm or shorter. When the distance between the irradiation port and the substrate is shorter than 0.5 mm, the emitted plume adheres to the irradiation port, the energy of the laser processing or the like is likely to become unstable, and there is a concern that the position accuracy may not be sufficiently maintained.

There is a concern that peaks to be observed by XPS may change due to the unstable output. On the other hand, when the focal distance is as far as longer than 30 mm, the adhesion of the plume or the like can be suppressed, but there is a concern that a subtle difference in the angle that is formed by the laser and the ceramic substrate 1, 2 or 4 may significantly affect the position accuracy. The focal distance is more preferably within a range of 1 mm or longer and 15 mm or shorter. In terms of the molecular density, the number of water molecules present per same distance is the same. Therefore, as the distance from the irradiation port becomes farther, the influence of the water molecules on the output energy of the laser becomes larger. In addition, there is a concern that the influence of the environment in which the laser processing is performed, such as the humidity or the temperature, may become excessive. Accordingly, there is a concern that peaks that are observed by XPS may also change.

At this time, Quantera SXM manufactured by ULVAC-PHI, Inc. was used. Therefore, it is preferable to use a device having equivalent or better performance. As an X-ray source, a single-crystal spectroscopy AlKα-ray was used. The X-ray output at this time was 4.5 W. In addition, the diameter in an analysis region was 20 µm.

The absolute value of a value obtained by subtracting a value in a non-irradiation region of the peak intensity of the strongest peak within a range of 528 eV or higher and 536 eV or lower from a value in an irradiation region of the peak intensity of the strongest peak within the above-described range (peak difference) is preferably 2500 or less and more preferably 1600 or less. The peak difference is more preferably 1500 or less and still more preferably 800 or more and 1500 or less. The absolute value of the peak intensity of the strongest peak within a range of 528 eV or higher and 536 eV or lower in the irradiation region is preferably 1000 or more. This value being 1000 or more indicates that the energy density of the laser is high and indicates that the magnitude of the heat effect on the non-irradiation region is suppressed. When the energy density is set to be high as described above, it is possible to decrease the width of a scribe groove, and it also becomes possible to improve the proportion of the area of the ceramic split substrates 4 to be obtained in the size of the entire ceramic laser-scribed substrate 1. In addition, the absolute value of the peak intensity of the strongest peak within a range of 528 eV or higher and 536 eV or lower in the irradiation region is preferably 3500 or less. This is because, when the absolute value is as large as more than 3500, an increase in the oxidation number of a Si component progresses excessively, and there is a concern that it may not be possible to control the value of I3/I2.

In addition, the absolute value of a value obtained by subtracting a value in a non-irradiation region of the peak intensity of the strongest peak within a range of 395 eV or higher and 400 eV or lower from a value in an irradiation region of the peak intensity of the strongest peak within the above-described range (peak difference) is preferably 2500 or less. The peak difference is more preferably 2200 or less. The peak difference is still more preferably 300 or more and 2000 or less. The peaks within this range are peaks derived from an oxide.

The peak difference being 300 or more indirectly indicates that the heat effect on the non-irradiation region is weak and the influence of the laser is confined to the irradiation region.

Furthermore, the absolute value of a value obtained by subtracting a value in a non-irradiation region of the peak intensity of the strongest peak within a range of 282 eV or higher and 288 eV or lower from a value in an irradiation region of the peak intensity of the strongest peak within the above-described range (peak difference) is preferably 2500 or less. The peak difference is more preferably 1200 or less. The non-irradiation region refers to a region in which a place 0.05 mm or more away from the laser-processed surface is centered in a measurement place.

This peak indicates the presence of carbon in the 1S orbital. The presence of carbon in the 1S orbital refers to the fact that the substrate has a bond with carbon and the bond with carbon is derived from a single bond.

Therefore, these three peak differences in peak intensity being small indicate that changes in the contents thereof are small depending on the presence or absence of the laser irradiation.

Therefore, these three peak differences in peak intensity are preferably set to 2500 or less. The three peak differences in peak intensity are more preferably 2000 or less. This peak difference is preferably a certain extent. Therefore, the peak difference is more preferably 1000 or less. Here, the peak difference refers to the absolute value of a value obtained by subtracting the intensity of a peak in the range in a non-irradiation region with the laser from the intensity of a peak in the range in an irradiation region with the laser.

A peak difference C_{E-F} in peak intensity within a range of E [eV] or higher and F [eV] or lower is represented by the following formula. CE-F = |(peak intensity within range of E [eV] or higher and F [eV] or lower in irradiation region) - (peak intensity within range of E [eV] or higher and F [eV] or lower in non-irradiation region)|

The peak difference can be indirectly obtained by comparing the heights of the obtained peaks and obtaining the magnitude of the difference in peak height between the irradiation region and the non-irradiation region.

Ceramic that is subjected to scribing more preferably contains one or more of alumina, zirconia, silicon nitride, sialon, and aluminum nitride as a main component. The main component refers to the fact that 50 wt% or more of the corresponding component is contained. The ceramic that is subjected to scribing is more preferably a Si-containing ceramic. Regarding the kind of ceramic, ceramic containing silicon nitride, sialon, or silicon carbide as the main component is more preferable. Ceramic containing silicon nitride as the main component is still more preferable.

The ceramic substrates 1, 2 and 4 are preferably Si-containing ceramic substrates. The Si-containing ceramic is more preferably silicon nitride, silicon carbide, or sialon. The thicknesses of the ceramic substrates 1, 2 and 4 that are used at this time are not particularly limited, but are preferably 0.1 mm or more and 3.00 mm or less and more preferably 0.2 mm or more and 2.5 mm or less. When the substrate is too thin, for example, less than 0.1 mm, the substrate is likely to be broken during transportation after the laser processing, and there is a concern that the transportation may be adversely affected. On the other hand, when the substrate is as thick as more than 3 mm, oxidation progresses excessively after the laser processing, and there is a concern that it may not be possible to make two or more peaks observable in any laser-processed surfaces.

In a case where the ceramic substrates 1, 2 and 4 are Si-containing ceramic substrates, according to the XPS spectra, when the peak intensity of the strongest peak within a range of 98 eV or higher and lower than 101 eV is indicated by I2, and the peak intensity of the strongest peak within a range of 101 eV or higher and 106 eV or lower is indicated by I3, I3/I2, which is a ratio between the peak intensities, is preferably 2.5 or less. This I2 indicates the intensity of a peak of Si-Si, and I3 indicates the peak intensity of Si-O. Therefore, the intensity ratio between the peaks of Si-O and Si-Si being adjusted to 2.5 or less means that an increase in the oxidation number of Si due to the heat effect caused by the laser processing has been reduced.

In addition, waveform separation is performed on the peaks obtained as described above, and the integral values are compared together. Here, the integral value indicates the area of the peak. Therefore, this integral value relies on the peak intensity and the half width. In a method for the waveform separation, the spectrum of the non-irradiation region and the main peak within a range of 98 eV or higher and 106 eV or lower are referred to.

When the peak integral value of the strongest peak within a range of 98 eV or higher and lower than 101 eV is indicated by S2, and the peak integral value of the strongest peak within a range of 101 eV or higher and 106 eV or lower is indicated by S3, S3/S2, which is a ratio between peak intensities, is preferably 0.8 or more and 4.2 or less. When not only the peak intensity but also the integral value of the peak are controlled as described above, it is possible to further control the ratio between a compound or pure element capable of forming a Si-Si bond and a compound capable of forming a Si-O bond generated.

In the scribe line 3 obtained with the laser, the depth thereof may be changed as appropriate depending on the application thereof or the like. For example, a laser processing depth D (shown in FIG. 3) can be changed as appropriate by changing the energy density or the like. As a method for changing the laser processing depth D as described above, the movement (scanning) speed of the sintered substrate may be changed. Examples of a method for changing the scanning speed include a change in the movement speed of the sintered substrate. The scanning speed can be appropriately changed as necessary, but there is a concern that too slow a scanning speed may make the heat effect of the energy of the laser excessive. Therefore, the sintered substrate is preferably scanned at a certain speed or faster.

On the laser-processed surface 6 of the ceramic laser-scribed substrate 1 shown in FIG. 3, an opening end portion 81 and an opening end portion 82 are end portions at two places on a perpendicular line to a laser scanning direction L in an opening portion (laser irradiation side) of a laser recessed portion 8. In contrast, the minimum angle (angle θ) at a deepest portion that is formed by the deepest portion that is present at the laser processing depth D of the laser recessed portion 8 and the two opening end portions 81 and 82 is preferably set to three degrees or more and less than 90 degrees. The angle θ is more preferably five degrees or more and 60 degrees or less. Furthermore, the angle θ is preferably five degrees or more and 45 degrees or less. As a still more preferable range, the angle θ is five degrees or more and less than 30 degrees. Controlling the angle θ as described above reduces wasted places (edge portions) at the time of splitting the ceramic laser-scribed substrate 1 along the scribe lines 3 or forming the notch portions 72 and leads to improvement in position accuracy at the time of breaking (splitting) or detachment. Not only does the position accuracy improve at the time of splitting, detachment or the like as described above, but it is also possible to prevent the ceramic laser-scribed substrate from being split when not wanted even when the angle θ becomes a sharp acute angle due to the presence of a formation layer having a different strength at the time of splitting or the like. In addition, on the laser-processed surface 6 of such a ceramic laser-scribed substrate 1, not only the laser recessed portion 8 that does not penetrate through the substrate, but a laser recessed portion that partially penetrates through the substrate (not shown) may be provided. That is, a penetrated laser processing mark and an unpenetrated place may coexist in one ceramic laser-scribed substrate 1.

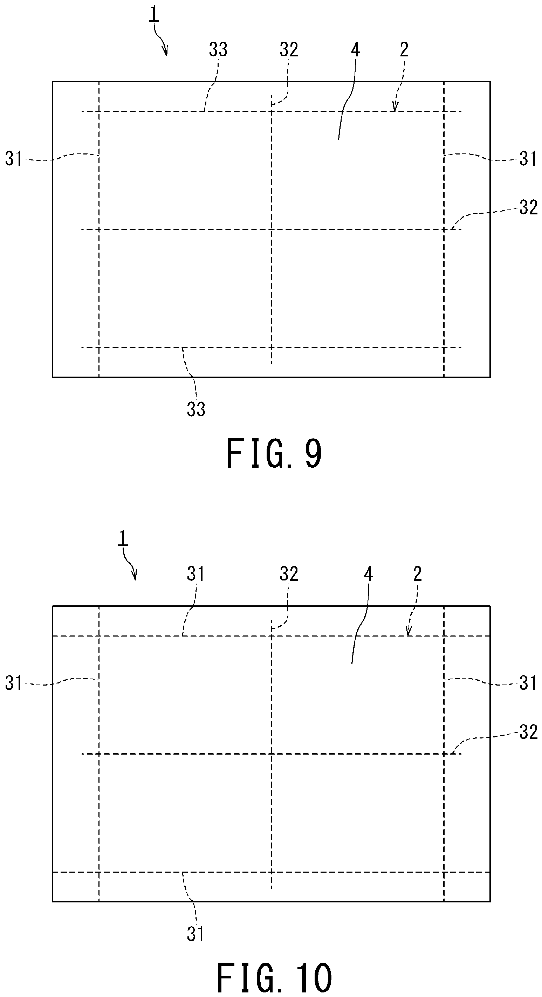

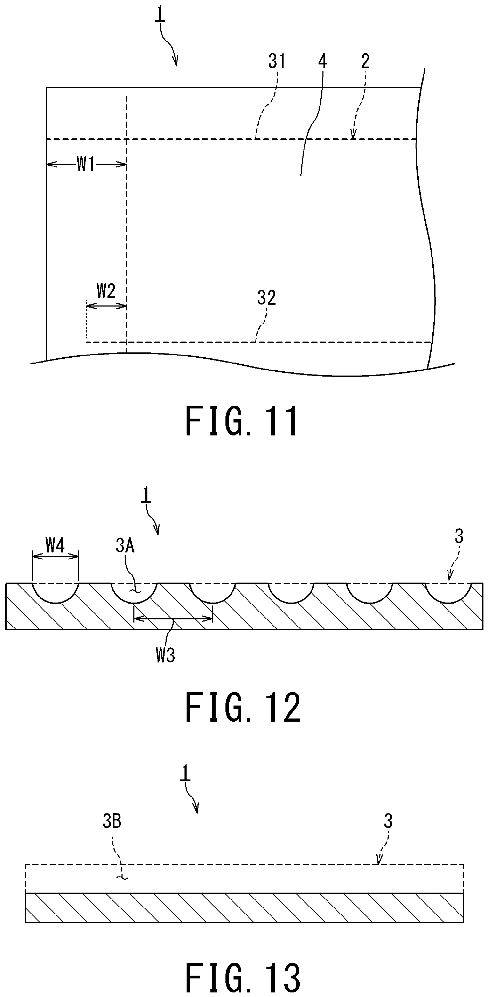

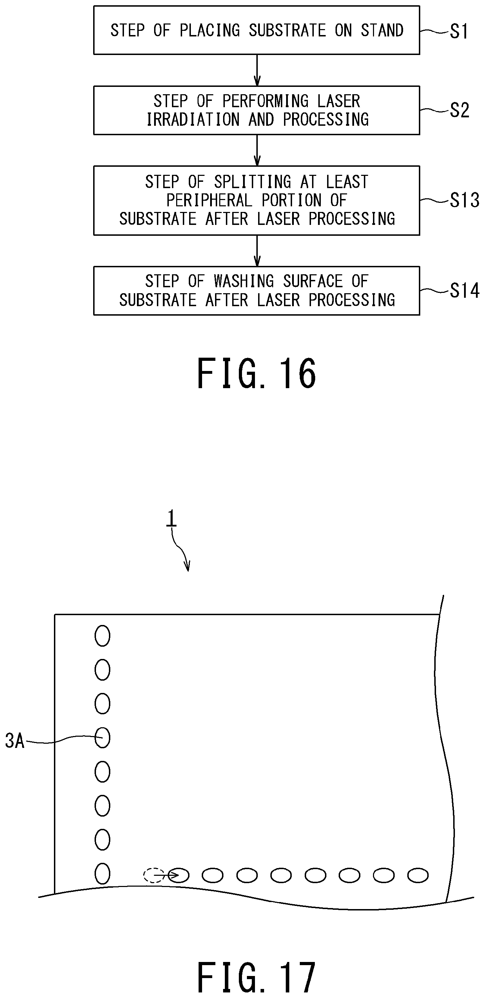

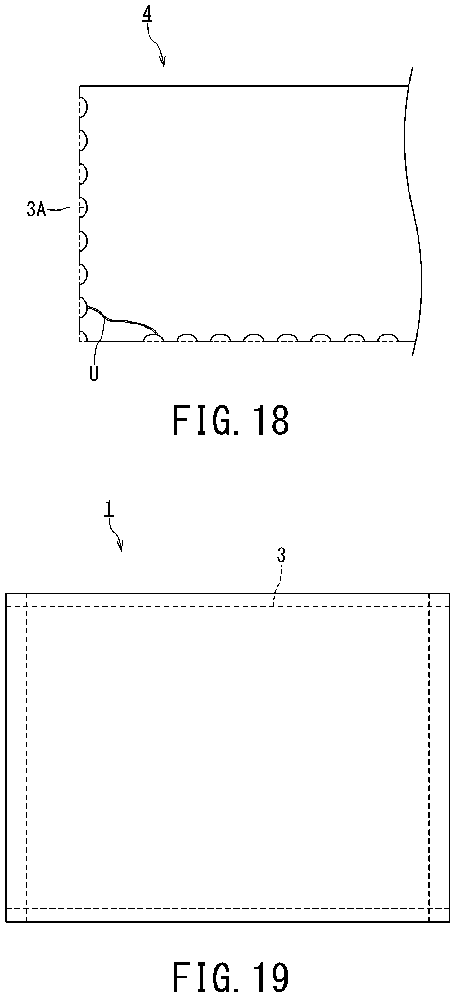

As shown in Figs. 8 to 10, the ceramic laser-scribed substrate 1 including the ceramic multipiece substrate 2 includes at least two scribe lines 31 that reach outside up to protruding edge portions from intersections with different scribe lines, scribe lines 32 between the ceramic substrates 4 adjacent to each other, and other scribe lines 33 (only shown in FIG. 8 and FIG. 9 among Figs. 8 to 10). The scribe lines 32 preferably protrude outside from the intersections between the scribe lines 31 and 33. For example, two scribe lines 31 extend in the horizontal direction in FIG. 8, two scribe lines 31 extend in the vertical direction in FIG. 9, and there are a total of four scribe lines 31, that is, two scribe lines extending in the horizontal direction and two scribe lines extending in the vertical direction, in FIG. 10. When the scribe lines 32 are designed to protrude from the intersections between the scribe lines 31 and 33 as described above, there is a concern that misalignment of a scribe dot (hereinafter, simply referred to as "dot") 3A (exemplified in FIG. 17) or poor splitting U at the time of breaking due to the dot 3A (exemplified in FIG. 18) may result. As shown in FIG. 11, the ceramic laser-scribed substrate 1 has a protrusion width W2 of the scribe line 32 relative to a protrusion width W1 of the scribe line 31, and the width W2 is more preferably 0.1 mm or more. A value (W2/W1) of the protrusion width W2 to the protrusion width W1 is preferably set to be 1/2 or less. When W2/W1 is set to be 1/2 or less as described above, the ceramic laser-scribed substrate 1 is not split (broken) unintentionally during transportation, and it also becomes possible to shorten the takt time. The W2/W1 is more preferably 1/4 or less.

As a separate step from the laser processing for splitting, the notch shape of the screw fastening portion or the like may be provided by laser processing. In addition, the laser processing for splitting is not performed, and only the notch portions 72 may be formed. Therefore, the shape of the laser-processed surface 6 of the ceramic substrate 1, 2 or 4 is not particularly limited. In addition, the timing of performing detachment such as splitting is not particularly limited. For example, such a detachment step may be performed twice separately, and a separate step may be provided therebetween.

The scanning speed of the sintered substrate may be freely changed, but the amount of the scanning speed changed is preferably more than 0 and 1500 mm/s or less to make two or more peaks be observed within a range of 98 eV or higher and 106 eV or lower regardless of the measurement range. Incidentally, there is a concern that it may be too expensive to make the amount of the scanning speed of the sintered substrate changed completely zero. Therefore, the amount of the scanning speed changed may exceed zero as long as the amount of the scanning speed changed on the sintered substrate is controlled to be as small as possible. This can be allowed in consideration of a possibility of the fact that it takes some time to stabilize the laser output.

In the laser processing of the sintered substrate, there are cases where a fine powder generated by the processing, which is referred to as a plume or the like, is generated. When being too close to the laser irradiation port, this plume adheres to this laser irradiation port, and there is a concern that the laser output may become unstable and, furthermore, the injection port may be blocked.

It is preferable to perform dust collection to suppress the adhesion of the plume or the like. An assist gas may also be used as necessary. At the time of performing this dust collection, a dust collector or the like is preferably used. The dust collector preferably has a filter or the like. In the case of using a dust collector having a structure with a filter as described above, it is preferable to remove the fine powder or the like that has adhered to the filter portion as necessary. When the fine powder that has adhered to the filter portion is removed as described above, it is possible to maintain a certain degree or more of a dust collecting force at all times. The dust collection also has an effect of suppressing the adhesion of the fine powder such as the generated plume to the substrate.

A deposit generated by the laser processing of the sintered substrate may be removed by a subsequent step; however, in a case where the deposit remains on the surface of the ceramic laser-scribed substrate 1, there is a possibility that the deposit may peel off. When the laser output is increased without performing dust collection, the processing speed can be increased, but damage that is imparted to the laser-processed surface 6 becomes large.

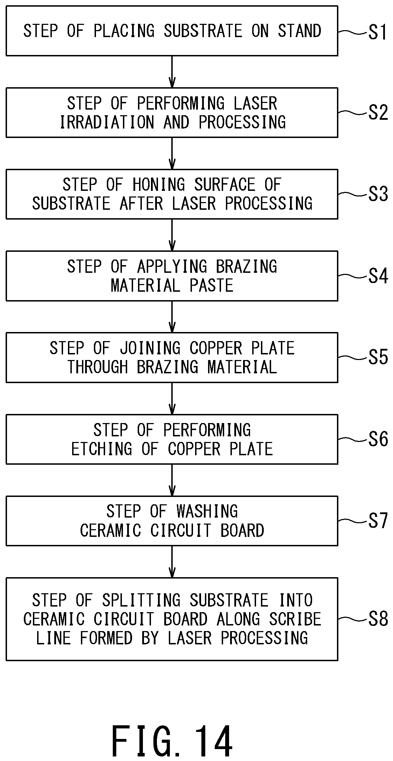

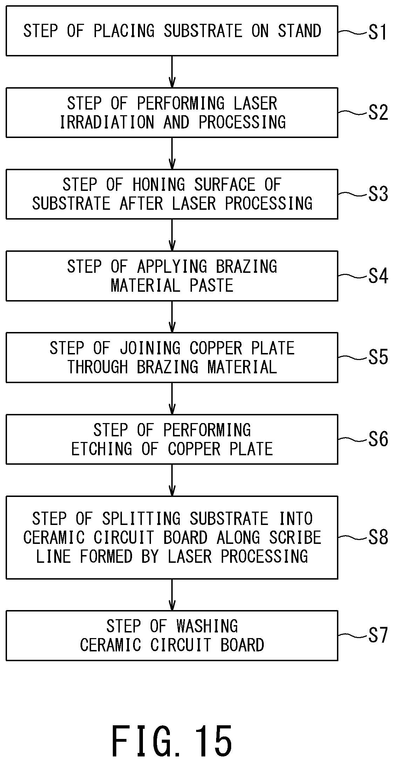

To the ceramic laser-scribed substrate 1 obtained by performing the laser processing on the sintered substrate, it is possible to join a conductor portion such as a metal plate to form a circuit portion (for example, the metal circuit 11 shown in FIG. 6). The laser processing may be performed after the conductor portion is joined to the sintered substrate and a circuit shape is then imparted. In this case, the metal circuit 11 is formed on the ceramic laser-scribed substrate 1, and the ceramic laser-scribed substrate is then split into the ceramic circuit boards 10 (shown in FIG. 14 and FIG. 15). Alternatively, the ceramic circuit boards 10 may be produced by forming the metal circuits 11 after the ceramic laser-scribed substrate 1 is split into the ceramic split substrates 4. Other steps may or may not be included between a laser processing step (step S2 shown in FIG. 14 and FIG. 15) and a splitting step (step S8) that is performed along the scribe lines after the laser processing.

Examples of metal that is used for the metal circuit 11 include copper (Cu), copper-based alloys, aluminum (Al), and the like. In the case of using copper as the metal circuit 11, the copper may be oxygen-free copper. The metal circuit 11 may be formed by etching or a conductor portion provided with a circuit shape in advance may be joined. Examples of a method for imparting this circuit shape in advance include a method called blanking and the like.

As shown in FIG. 6, the ceramic split substrate (product part) 4 and the metal circuit 11 are preferably joined together through a joining layer (for example, a brazing material layer 13). Even in a case where a metal heat dissipation plate 12 is joined to the ceramic split substrate 4, the ceramic split substrate and the metal heat dissipation plate are preferably joined together through the joining layer (for example, the brazing material layer 13). As the brazing material layer 13 between the ceramic split substrate 4 and the metal circuit 11, an active metal brazing material containing an active metal such as Ti (titanium) is preferably provided. Examples of the active metal include, aside from Ti, Zr (zirconium), Nb (niobium), Hf (hafnium), and the like. Therefore, other active metals may be used instead of Ti. Examples of a method for providing the joining layer as described above include a method in which a brazing material paste is used and a method in which an alloy foil is used.

Therefore, the method may be the use of a foil or the use of a brazing material paste as long as the joining layer can be provided. Examples of the active metal brazing material include mixtures containing, aside from Ti, any one of Ag (silver) or Cu as the main component. The mixtures are preferably made to contain 0.1 wt% or more and 10 wt% or less of Ti and 5 wt% or more and 96 wt% or less of Cu. In addition, a total of 1 wt% or more and 35 wt% or less of one or more selected from In (indium), Sn (tin), Al, Si (silicon), C (carbon), Mg (magnesium), Mo (molybdenum), Mn (manganese), W (tungsten), Re (rhenium), and Os (osmium) may be added thereto as necessary. Ag is the remainder. Therefore, Ag does not need to be contained at all times. In a metal joining method in which the active metal brazing material is used, an active metal brazing material paste is applied to the surface of the ceramic split substrate 4, and the metal circuit 11 are disposed thereon. The ceramic split substrate and the metal circuit are heated at 600 degrees Celsius or higher and 900 degrees Celsius or lower to be joined together. For the joining, a method in which vacuuming is required may be used, and the ceramic split substrate and the metal circuits may be joined together in an inert atmosphere. Examples of the inert atmosphere include a nitrogen atmosphere (the mole fraction is 80% or higher and more preferably 85% or higher), a rare gas atmosphere (an argon atmosphere or a neon atmosphere), and the like.

According to the active metal joining method, it is possible to make the joining strength between the ceramic split substrate 4 and the metal circuit 11 be 16 kN/m or higher.

A thin metal film containing one selected from Ni (nickel), Ag (silver), or Au (gold) as the main component may be provided on the surface of the metal circuit 11. Examples of this thin metal film include a plated film, a sputtered film, and the like. The thin metal film provided makes it possible to improve corrosion resistance or solder wettability. The film may be partially provided or may cover the entire conductor portion. The ceramic circuit board 10 is not limited only to a structure of a metal plate/a ceramic substrate/a metal plate as shown in FIG. 6 and may be a five-layer structure of a metal plate/a ceramic substrate/a metal plate/a ceramic substrate/a metal plate. The metal plate mentioned herein may be a metal plate imparted with a circuit shape or a metal plate having a groove shape on the surface.

In the embodiment shown in FIG. 6, the joining area between the ceramic split substrate 4 and the metal heat dissipation plate 12 and the joining area between the ceramic split substrate 4 and the metal circuits 11 are different from each other, but may be the same as each other. In addition, the thicknesses of these metals may be the same as or different from each other. Furthermore, the metal heat dissipation plate 12 and the ceramic split substrate 4 may be joined together through the brazing material layer 13. In addition, a conductor portion other than the brazing material layer 13 may be provided between the metal heat dissipation plate 12 and the ceramic split substrate 4.

Such a ceramic circuit board 10 is suitable for a semiconductor module in which a semiconductor element is mounted on the metal circuit 11 through a joining layer.

An electronic component such as a semiconductor element may be mounted on the obtained ceramic circuit board 10. Aside from the semiconductor element, a wire bond and the metal circuit 11 may be joined thereto. A semiconductor module may be produced by performing resin molding on the wire-bonded ceramic circuit board 10. The structure of the semiconductor module according to the embodiment is not limited. For example, the structure may be any one of a wire bond and a lead frame. The numbers of the semiconductor elements, the wire bonds, and the lead frames provided on the metal circuit 11 may be each plural.

Examples of the joining layer that joins the semiconductor element or the lead frame include solder, brazing materials, and the like. The solder is preferably lead-free solder. The solder refers to solder having a melting point of 450 degrees Celsius or lower. The brazing materials refer to brazing materials having a melting point of higher than 450 degrees Celsius. In addition, brazing materials having a melting point of 500 degrees Celsius or higher are referred to as high-temperature brazing materials. Examples of the high-temperature brazing materials include brazing materials containing Ag as the main component. Examples of the brazing materials containing Ag as the main component include Ag pastes having a controlled particle diameter, Cu pastes containing Cu as the main component, and the like.

In the case of sealing the ceramic circuit board 10 with a resin mold, the laser-scribed surface may be on a side opposite to the metal circuit 11 (the metal heat dissipation plate 12 side). This is because a resin is less likely to flow into a recessed portion generated by laser scribing and there is a possibility that the recessed portion may become a void. The void hinders heat dissipation, and it is thus preferable to form the scribe line on the heat dissipation plate side to suppress the generation of the void.

While the size reduction of semiconductor elements is in progress, the amount of heat generated from a chip is continuously increasing. Therefore, in the ceramic circuit board 10 on which a semiconductor element is mounted, improvement in heat dissipation is important. In addition, for improvement in the performance of a semiconductor device (semiconductor module), a plurality of semiconductor elements are mounted on the ceramic circuit board 10. Even a single semiconductor element exceeding the intrinsic temperature of the element makes resistance change to a negative temperature coefficient. Accordingly, a phenomenon in which thermal runaway, which is an intensive flow of electric power, occurs and the semiconductor element instantly breaks occurs. Therefore, it is effective to improve heat dissipation. A semiconductor device according to the embodiment can be used in PCUs (power control units), IGBTs (insulated gate bipolar transistors), and IPM (intelligent power module) modules that are used in inverters for automobiles (including electric vehicles), electric railway vehicles, industrial machinery, air conditioners, and the like. The proportion of electric vehicles in automobiles is continuously increasing. Improvement in the reliability of the semiconductor device directly leads to the safety of automobiles. This is also true for electric railway vehicles, industrial machinery, and the like.

Next, a method for the laser scribing of the silicon nitride substrate among the ceramic substrates 1, 2 and 4 according to the embodiment will be described. As long as the laser scribing of the silicon nitride substrate has the above-described configuration, the laser scribing method is not particularly limited, but the following method will be exemplified as a method for obtaining a laser-scribed silicon nitride substrate with a favorable yield.

First, a silicon nitride substrate is prepared. Particularly, in consideration of the heat dissipation of the entire ceramic circuit board 10, it is preferable that the thermal conductivity is 50 W/m·K or higher and the three-point bending strength is 600 MPa or higher. Examples of the silicon nitride substrate having a thermal conductivity of 50 W/m·K or higher and a three-point bending strength of 600 MPa or higher include silicon nitride substrates having a thermal conductivity of 130 W/m·K and a three-point bending strength of 750 MPa.

When the metal circuit 11 on the ceramic circuit board 10 and the metal heat dissipation plate 12 are electrically connected together through a penetration hole, a silicon nitride substrate having a penetration hole is prepared. In the case of providing a penetration hole to the silicon nitride substrate, the penetration hole may be provided in advance in the stage of a compact. A step of providing a penetration hole (for example, through hole) 71 to a silicon nitride sintered body may also be performed. Examples of the step of providing a penetration hole include laser processing similar to the laser scribing, cutting, and the like. Examples of the cutting include drilling with a drill and the like.

The scribe line 3 may be formed not as a continuous groove 3B shown in FIG. 13 but as a combination of a dot 3A and a shallow continuous groove 3B (not shown) and may be formed only as a dot 3A as shown in FIG. 12. Here, the dot 3A is composed of a laser processing mark that is separated from another mark without overlap, but the continuous groove 3B is composed of laser processing marks that at least partially overlap one another. In a case where the scribe line 3 is formed of the dots 3A, the average value of widths W3 (shown in FIG. 12) between places where each dot 3A becomes deepest is preferably 50 µm or more and 300 µm or less. The average value of the widths W3 is more preferably 50 µm or more and 150 µm or less. A width W4 (shown in FIG. 12) of a scribe mark of the dot 3A is preferably controlled to be 20 µm or more and 100 µm or less. The depth of the dot 3A is preferably 1/6 or more and 2/3 or less of the substrate thickness. The depth of the dot 3A is preferably 50 µm or more and 300 µm or less. The depth of the dot 3A is more preferably 150 µm or more and 250 µm or less. In the laser processing, it is preferable to form, aside from the dot 3A (shown in FIG. 12) or the continuous groove 3B (shown in FIG. 13), an auxiliary cut line (auxiliary continuous groove or dot) by partially irradiating the surrounding of the dot 3A or the continuous groove 3B a plurality of times in the scribe line. In the step S2 shown in FIG. 14 to FIG. 16, the scribe line 3 is formed by forming an auxiliary cut line in addition to the dot 3A or the continuous groove 3B, whereby the defect rate during splitting can be further reduced.

It is preferable to provide a step of placing the substrate on a stand (stage) (step S1) before a step of providing the scribe line 3 to the ceramic substrate 1, 2 or 4 (step S2) and to provide a step of washing the surface using honing, blasting or the like (step S3) after the step of providing the scribe line 3 (step S2). Furthermore, a step of washing the surface (step S14) may be provided after a step of splitting a peripheral portion (step S13) as shown in FIG. 16. As shown in FIG. 14 and FIG. 15, a step of splitting the substrate into the ceramic circuit board 10 (step S8) may be performed after a step of joining a copper plate (step S5). It is more preferable to have a step of washing the ceramic circuit board 10 (step S7) after the step of splitting into the ceramic circuit board 10 (step S8) as shown in FIG. 15 than to have a step of washing the ceramic circuit board 10 to be split (step S7) before the step of splitting into the ceramic circuit board 10 (step S8) as shown in FIG. 14. This is because there is a concern that a fine powder or the like that is generated during splitting may adhere and the powder should be washed in the step S7. The scribe line 3 may be a scribe line only for splitting only the peripheral portion as shown in FIG. 19.

The silicon nitride substrate is set on a precision processing table of a laser processing machine such as a fiber laser (step S1). The silicon nitride substrate is irradiated with the laser to form a laser processing mark such as the scribe line 3 composed of the dots 3A (shown in FIG. 12). At this time, the dots 3A having a predetermined size are formed depending on the conditions of the laser processing machine 14 (shown in FIG. 7). The laser processing is preferably performed by moving the precision processing table. This is because, when the laser processing is controlled by moving the laser or changing the direction of the mirror at the time of the processing, there is a concern that the adjustment of the scanning speed may become difficult.

To the silicon nitride substrate on which the scribe line 3 has been formed, that is, to the ceramic laser-scribed substrate 1, metal plates (the metal circuit 11 and the metal heat dissipation plate 12) are joined.

The silicon nitride substrate and the metal plates are preferably joined together by an active metal joining method. In the active metal joining method, an active metal brazing material into which an active metal such as Ti has been mixed is used. Examples of the active metal brazing material include mixtures of Ti and Cu. In addition, Ag may be added to this active metal brazing material as necessary. In the case of adding Ag thereto, the content thereof is preferably 99.5 wt% or less. The content thereof is more preferably 95 wt% or less. When the content of Ag is controlled as described above, an effect of making ion migration less likely to occur can be expected. It is known that ion migration is likely to occur when Ag is added compared with when Cu is added. Incidentally, when a large amount of silver is contained, the reliability of joining at high temperatures increases. Therefore, it is more preferable to freely adjust the amount of silver within a range of 0 wt% or more and 95 wt% or less depending on the necessity or the application. For example, the content of Ti is 0.1 wt% or more and 10 wt% or less, the content of Cu is 0.5 wt% or more and 60 wt% or less, and Ag is the remainder.

Therefore, Ag does not need to be contained at all times, and approximately 95 wt% of Ag may be contained. In addition, a total of 1 wt% or more and 35 wt% or less of one or more selected from In, Sn, Al, Si, C, Mg, Mo (molybdenum), Mn (manganese), W (tungsten), Re (rhenium), and Os (osmium) may be added. The active metal brazing material is made into a paste. The paste is obtained by mixing the brazing material component and an organic substance, and the brazing material component needs to be uniformly mixed. This is because, when the brazing material component is not uniformly distributed, brazing is not stable, and joining becomes poor.

The active metal brazing material paste is applied to the ceramic laser-scribed substrate 1. A copper plate is disposed thereon. Next, a step of joining the ceramic laser-scribed substrate and the copper plate by heating at 600 degrees Celsius or higher and 900 degrees Celsius or lower is performed. The heating step is performed in a vacuum or in a non-oxidative atmosphere as necessary. In the case of performing the heating step in a vacuum, the pressure is preferably 1 × 10⁻² Pa or lower. Examples of the non-oxidative atmosphere include a nitrogen atmosphere, an argon atmosphere, a helium atmosphere, a neon atmosphere, and the like. Here, the non-oxidative atmosphere is not particularly limited and refers to an atmosphere where the oxygen partial pressure is 10% or lower.

When the heating step is performed in a vacuum or in the non-oxidative atmosphere, it is possible to suppress the oxidation of the joining layer. This improves the joining strength.

The conductor portion to be joined may be either of a conductor portion that has been processed in advance into a pattern shape for circuit formation or a single plate on which no pattern processing is performed. In the case of using a single plate, the single plate is processed into a pattern shape by performing etching after joining. At this time, the metal circuit 11 may be formed on a surface opposite to the surface on which the scribe line has been formed. This step makes it possible to manufacture a silicon nitride metal circuit board as the ceramic circuit board 10.

Next, a step of joining a semiconductor element or the like to the silicon nitride metal circuit board is performed. A joining layer is provided at a place where the semiconductor element is to be joined. The joining layer may be solder or a brazing material or may be a silver layer for which a silver paste or the like is used. The joining layer may be a copper layer for which a copper paste is used. The joining layer is provided, and the semiconductor element is provided thereon. In addition, a lead frame is joined through the joining layer as necessary. In addition, a wire bond is provided as necessary. Necessary numbers of semiconductor elements, lead frames, and wire bonds are provided. The silicon nitride metal circuit board provided with the semiconductor elements, the lead frames, and the wire bonds is molded with a resin, thereby sealing the inside.

A method for the laser scribing of the silicon carbide substrate among the ceramic substrates 1, 2 and 4 according to the embodiment will be described. First, a silicon carbide substrate is prepared. Particularly, in consideration of the heat dissipation of the entire ceramic circuit board 10, it is preferable that the thermal conductivity is 150 W/m·K or higher and the three-point bending strength is 400 MPa or higher. As long as the laser scribing of the silicon carbide substrate has the above-described configuration, a manufacturing method thereof is not particularly limited; however, as a method for obtaining a laser-scribed silicon nitride substrate with a favorable yield, the same method as those for the silicon nitride substrate and the silicon nitride metal circuit board is used.

### (Examples 1 to 22 and Comparative Examples 1 to 7)

As ceramic substrates 1, 2 and 4, silicon nitride substrates that were 200 mm in length, 180 mm in width, and 0.32 mm and 0.50 mm in thickness (the thermal conductivity was 90 W/m·K and the three-point bending strength was 650 MPa) were prepared.

In addition, silicon carbide substrates that were 200 mm in length, 180 mm in width, and 0.635 mm and 0.80 mm in thickness (the thermal conductivity was 300 W/m·K and the three-point bending strength was 400 MPa) were prepared.

Next, dust collection was performed on a single surface of a substrate (for example, a sintered substrate) that was to serve as the source of a ceramic laser-scribed substrate, and laser processing was performed with a fiber laser under conditions of each of Examples 1 to 22 and Comparative Examples 1 to 7 to draw eight split substrates per substrate. Two hundred substrates were prepared. The processed shapes are as shown in Table 2. Scribe lines in Examples 2 to 4, 10 to 12, 18, and 21 and Comparative Examples 1 and 4 shown in Table 2 correspond to dots. For cases where both conditions of the temperature and the humidity were satisfied, "O (circle)" is entered into the "temperature and humidity" column in Table 1, and for cases where any one was not satisfied, "X (cross)" is entered thereinto.

In addition, for cases where "O (circle)" is entered into the "laser condition" column in Table 1, the pulse width was set to be on the order of nanoseconds or shorter, and dust collection was performed. For cases where "focal distance" satisfied conditions, "O (circle)" is entered into the "focal distance" column. In the laser processing in comparative examples, assist gases were not used.

Steps described below, such as transportation, (referred to as post steps) were performed on the ceramic substrates that had been subjected to the laser processing under the respective conditions. The steps described below are honing, washing, drying, and transportation.

Substrates broken (split) partially or along the scribe lines or off the break lines at the time of performing such steps are shown in Table 2 as split proportions.

In addition, angles θ formed by the deepest portion of a groove portion and two places (both end portions) at an opening end portion were obtained. The angles θ are shown in the "laser-processed angle" column in Table 2.

Measurement results of the examples and the comparative examples are shown in Table 1 and Table 2. Silicon nitride (Si₃N₄) substrates are denoted as "SiN", and silicon carbide substrates are denoted as "SiC" in Table 1.

**[Table 1]**

| | Substrate Type | Substrate Thickness [mm] | Laser-Related Conditions | | |
|---|---|---|---|---|---|
| | | | Focal Distance | Humidity & Temperature | Laser Condition |
| Example 1 | SiN | 0.32 | O | O | O |
| Example 2 | SiN | 0.32 | O | O | O |
| Example 3 | SiN | 0.32 | O | O | O |
| Example 4 | SiN | 0.32 | O | O | O |
| Example 5 | SiN | 0.64 | O | O | O |
| Example 6 | SiN | 0.64 | O | O | O |
| Example 7 | SiN | 0.64 | O | O | O |
| Example 8 | SiN | 0.64 | O | O | O |
| Example 9 | SiN | 0.64 | O | O | O |
| Example 10 | SiN | 0.64 | O | O | O |
| Example 11 | SiN | 0.64 | O | O | O |
| Example 12 | SiN | 0.64 | O | O | O |
| Example 13 | SiN | 1.00 | O | O | O |
| Example 14 | SiN | 1.00 | O | O | O |
| Example 15 | SiN | 1.50 | O | O | O |
| Example 16 | SiN | 3.00 | O | O | O |
| Example 17 | SiC | 0.64 | O | O | O |
| Example 18 | SiC | 0.32 | O | O | O |
| Example 19 | SiC | 1.00 | O | O | O |
| Example 20 | SiC | 1.50 | O | O | O |
| Example 21 | SiC | 2.00 | O | O | O |
| Example 22 | SiC | 3.00 | O | O | O |
| Comparative Example 1 | SiN | 0.32 | X | X | X |
| Comparative Example 2 | SiN | 0.64 | X | X | X |
| Comparative Example 3 | SiN | 0.64 | X | X | X |
| Comparative Example 4 | SiN | 0.64 | X | X | X |
| Comparative Example 5 | SiC | 0.64 | X | X | X |
| Comparative Example 6 | SiC | 0.64 | X | X | X |
| Comparative Example 7 | SiC | 1.20 | X | X | X |

**[Table 2]**

| | Processed Shape | Split Proportion | Laser-Processed Angle [°] |
|---|---|---|---|
| Example 1 | Scribe Line (Dot) | 1.0% | 30 |
| Example 2 | Scribe Line & Notch Portion | 3.0% | 15 |
| Example 3 | Scribe Line & Notch Portion | 3.0% | 20 |
| Example 4 | Scribe Line & Notch Portion | 2.5% | 35 |
| Example 5 | Scribe Line (continuous groove) | 3.5% | 45 |
| Example 6 | Scribe Line (continuous groove) | 0.5% | 25 |
| Example 7 | Scribe Line (Dot) | 0.0% | 5 |
| Example 8 | Scribe Line (Dot) | 0.5% | 30 |
| Example 9 | Scribe Line (Dot) | 1.5% | 15 |
| Example 10 | Scribe Line & Notch Portion | 2.5% | 20 |
| Example 11 | Scribe Line & Notch Portion | 3.5% | 35 |
| Example 12 | Scribe Line & Notch Portion | 2.5% | 45 |
| Example 13 | Scribe Line (Dot) | 3.0% | 25 |
| Example 14 | Scribe Line (Dot) | 3.0% | 5 |
| Example 15 | Scribe Line (Dot) | 2.5% | 25 |
| Example 16 | Scribe Line (Dot) | 1.0% | 15 |
| Example 17 | Scribe Line (Dot) | 1.5% | 5 |
| Example 18 | Scribe Line & Notch Portion | 3.0% | 3 |
| Example 19 | Scribe Line (continuous groove) | 2.0% | 27 |
| Example 20 | Scribe Line (Dot) | 1.0% | 42 |
| Example 21 | Scribe Line & Notch Portion | 3.0% | 55 |
| Example 22 | Scribe Line (continuous groove) | 1.5% | 25 |
| Comparative Example 1 | Scribe Line & Notch Portion | 6.0% | 95 |
| Comparative Example 2 | Scribe Line (continuous groove) | 7.0% | 55 |
| Comparative Example 3 | Scribe Line (Dot) | 8.0% | 25 |
| Comparative Example 4 | Scribe Line & Notch Portion | 7.5% | 65 |
| Comparative Example 5 | Scribe Line (continuous groove) | 8.5% | 60 |
| Comparative Example 6 | Scribe Line (continuous groove) | 5.5% | 30 |
| Comparative Example 7 | Scribe Line (continuous groove) | 4.5% | 70 |

For the ceramic substrates 1, 2 and 4 according to Examples 1 to 17, the conditions in the laser processing and the like were within the scope of the preferable embodiment. On the other hand, the ceramic substrates according to Comparative Examples 1 to 7 were outside the scope of the preferable embodiment. Notch portions described in the present examples are notch portions as shown by Reference sign 72 in FIG. 1.

Next, the substrates were split under each of the conditions, and the laser-processed surfaces out of the split places were measured by XPS. Table 3 and Table 4 show the measurement results. A device used for the measurement was Quantera SXM manufactured by ULVAC-PHI, Inc.

The X-ray source was a single-crystal spectroscopy AlKα-ray. The X-ray output was 4.5 W, the diameter of the analysis region was ϕ20 µm, the geometry was 45 degrees, and the pass energy was -69.00 eV (0.125 eV/step).

**[Table 3]**

| | Peak observed within Range of 98 eV or Higher and 106 eV or Lower | | | | |
|---|---|---|---|---|---|
| | Presence or Absence of Two or More Peaks within Range of 98 eV or Higher and 106 eV or Lower | Peak Intensity I2 within Range of 98 eV or Higher and 101 eV or Lower | Peak Intensity I3 within Range of 101 eV or Higher and 106 eV or Lower | Ratio between Peak Intensities [I3/I2] | Ratio between Integral Values of Peak [S3/S2] |
| Example 1 | Presence | 1500 | 1600 | 1.0666667 | 1.1 |
| Example 2 | Presence | 1650 | 1450 | 0.8787879 | 0.9 |
| Example 3 | Presence | 1500 | 1350 | 0.90 | 0.9 |
| Example 4 | Presence | 1650 | 1400 | 0.8484848 | 0.8 |
| Example 5 | Presence | 300 | 1560 | 5.2 | 5.4 |
| Example 6 | Presence | 500 | 1620 | 3.24 | 3.3 |
| Example 7 | Presence | 800 | 1250 | 1.5625 | 1.5 |
| Example 8 | Presence | 150 | 1600 | 10.666667 | 11 |
| Example 9 | Presence | 1300 | 1500 | 1.1538462 | 1.3 |
| Example 10 | Presence | 1600 | 1450 | 0.90625 | 0.9 |
| Example 11 | Presence | 800 | 700 | 0.875 | 0.8 |
| Example 12 | Presence | 1000 | 1250 | 1.25 | 1.3 |
| Example 13 | Presence | 1300 | 1600 | 1.2307692 | 1.2 |
| Example 14 | Presence | 700 | 300 | 0.4285714 | 0.4 |
| Example 15 | Presence | 600 | 1500 | 2.5 | 2.5 |
| Example 16 | Presence | 2000 | 1340 | 0.67 | 0.7 |
| Example 17 | Presence | 1850 | 1600 | 0.8648649 | 0.8 |
| Example 18 | Presence | 1500 | 1000 | 0.6666667 | 0.7 |
| Example 19 | Presence | 1450 | 1250 | 0.862069 | 0.9 |
| Example 20 | Presence | 1350 | 950 | 0.7037037 | 0.7 |
| Example 21 | Presence | 1200 | 650 | 0.5416667 | 0.5 |
| Example 22 | Presence | 1450 | 1250 | 0.862069 | 0.9 |
| Comparative Example 1 | Absence | - | - | - | - |
| Comparative Example 2 | Absence | - | - | - | - |
| Comparative Example 3 | Absence | - | - | - | - |
| Comparative Example 4 | Absence | - | - | - | - |
| Comparative Example 5 | Absence | - | - | - | - |
| Comparative Example 6 | Absence | - | - | - | - |
| Comparative Example 7 | Absence | - | - | - | - |

**[Table 4]**

| | Peak Difference C₅₂₈₋₅₃₆ in 528eV-536eV | Peak Difference C₃₉₅₋₄₀₀ in 395eV-400eV | Peak Difference C₂₈₂₋₂₈₈ in 282eV-288eV |
|---|---|---|---|
| Example 1 | 300 | 2500 | 300 |
| Example 2 | 450 | 650 | 250 |
| Example 3 | 600 | 1500 | 400 |
| Example 4 | 1000 | 450 | 450 |
| Example 5 | 2500 | 800 | 200 |
| Example 6 | 2000 | 2000 | 100 |
| Example 7 | 1200 | 2100 | 50 |
| Example 8 | 1000 | 2400 | 480 |
| Example 9 | 800 | 2250 | 500 |
| Example 10 | 700 | 2150 | 550 |
| Example 11 | 450 | 1850 | 600 |
| Example 12 | 250 | 1450 | 420 |
| Example 13 | 700 | 1650 | 360 |
| Example 14 | 550 | 1200 | 380 |
| Example 15 | 1000 | 1150 | 120 |
| Example 16 | 800 | 1350 | 160 |
| Example 17 | 1150 | - | 370 |
| Example 18 | 650 | - | 580 |
| Example 19 | 500 | - | 360 |
| Example 20 | 600 | - | 410 |
| Example 21 | 450 | - | 470 |
| Example 22 | 500 | - | 340 |
| Comparative Example 1 | - | - | - |
| Comparative Example 2 | - | - | - |
| Comparative Example 3 | - | - | - |
| Comparative Example 4 | - | - | - |
| Comparative Example 5 | - | - | - |
| Comparative Example 6 | - | - | - |
| Comparative Example 7 | - | - | - |

As is clear from Table 3 and Table 4, in the ceramic substrates 1, 2 and 4 according to all of Examples 1 to 22, the numbers of peaks within a range of 98 eV or higher and 106 eV or lower measured by XPS were within the preferable range.

When the examples and the comparative examples are compared with each other using Table 1 to Table 4, in the comparative examples, the broken proportions in the post steps were as large as 4% or more regardless of the laser processing angles. On the other hand, in the examples where preferable peaks were shown in XPS, the broken proportions were all as small as less than 4%.

It is found that, when two or more peaks were observed within a range of 98 eV or higher and 106 eV or lower, the laser-processed surface was strengthened, and unnecessary splitting (breaking) did not occur. The two or more peaks were observed on arbitrary laser-processed surfaces.

In addition, defects (fissures, chips, and cracks) in the broken places were not observed in the examples. On the other hand, these defects were observed in some of the comparative examples.

These defects are considered to arise from the unstable outputs (due to the adhesion of a plume to the irradiation port or the like) in the laser processing.

Therefore, it was found that it is important to optimize a variety of conditions in the laser processing and to control XPS spectra to be obtained.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

### REFERENCE SIGNS LIST

1...Ceramic Substrate (e.g. Ceramic Laser-Scribed Substrate)
2...Ceramic Substrate (e.g. Ceramic Multipiece Substrate)
3...Scribe Line
4...Ceramic Substrate (e.g. Ceramic Split Substrate (Product Part))
5...Peripheral Portion (Non-Product Part)
6...Laser-Processed Surface
7...Penetration Hole
71...Penetration Hole (e.g. Through Hole)
72...Penetration Hole (e.g. Notch Portion)
8...Laser Recessed Portion
9...Non-Laser-Irradiation Surface (Non-Laser-Processed Surface)
10...Ceramic Circuit Board
11...Metal Circuit
12...Metal Heat Dissipation Plate
13...Brazing Material Layer
14...Laser Processing Machine
15...Fine Particles generated by Laser Irradiation
16...Dust Collector
W1...Protrusion Width of Peripheral Portion
W2...Protrusion Width of Scribe Line

## Claims

1. A ceramic substrate, wherein, in a spectrum obtained by measuring a laser-irradiated zone on a laser-processed surface by X-ray Photoelectron Spectroscopy (XPS), there are two or more peaks within a range of 98 eV or higher and 106 eV or lower.

2. The ceramic substrate according to claim 1, wherein, in the spectrum obtained by measuring the laser-irradiated zone by the XPS, when a peak intensity of a strongest peak within a range of 98 eV or higher and lower than 101 eV is indicated by I2, and a peak intensity of a strongest peak within a range of 101 eV or higher and 106 eV or lower is indicated by I3, I3/I2, which is a ratio between the peak intensities, is 0.4 or more and 12 or less.

3. The ceramic substrate according to claim 1, wherein, in the spectrum obtained by measuring the laser-irradiated zone by the XPS, when a peak intensity of a strongest peak within a range of 98 eV or higher and lower than 101 eV is indicated by I2, and a peak intensity of a strongest peak within a range of 101 eV or higher and 106 eV or lower is indicated by I3, I3/I2, which is a ratio between the peak intensities, is 0.6 or more and 4.5 or less.

4. The ceramic substrate according to any one of claims 1 to 3, wherein, in spectra obtained by measuring the laser-irradiated zone and a laser-non-irradiated zone by the XPS, an absolute value of a value obtained by subtracting a value of a peak intensity of a strongest peak in a non-irradiation region within a range of 528 eV or higher and 536 eV or lower from a value in an irradiation region of a peak intensity of a strongest peak within the range is 1600 or less.

5. The ceramic substrate according to any one of claims 1 to 4, wherein, in spectra obtained by measuring the laser-irradiated zone and a laser-non-irradiated zone by the XPS, an absolute value of a value obtained by subtracting a value of a peak intensity of a strongest peak in a non-irradiation region within a range of 395 eV or higher and 400 eV or lower from a value in an irradiation region of a peak intensity of a strongest peak within the range is 2500 or less.

6. The ceramic substrate according to any one of claims 1 to 5, wherein, in spectra obtained by measuring the laser-irradiated zone and a laser-non-irradiated zone by the XPS, an absolute value of a value obtained by subtracting a value of a peak intensity of a strongest peak in a non-irradiation region within a range of 282 eV or higher and 288 eV or lower from a value in an irradiation region of a peak intensity of a strongest peak within the range is 2500 or less.

7. The ceramic substrate according to any one of claims 1 to 6 that is a Si-containing ceramic substrate.

8. A ceramic circuit board, wherein a circuit portion is formed on a surface of the ceramic substrate according to claim 1.

9. The ceramic circuit board according to claim 8, wherein a metal circuit as the circuit portion is formed on any one or more surfaces of a surface irradiated with a laser or a surface opposite to the laser-irradiated surface.

10. The ceramic circuit board according to claim 8, wherein the circuit portion contains any one or more selected from aluminum, an aluminum alloy, copper, and a copper alloy.

11. The ceramic circuit board according to claim 10 that has been molded with a resin.

12. A semiconductor device, wherein a semiconductor element is mounted on the ceramic circuit board according to claim 8.

13. A method for manufacturing a ceramic substrate, wherein the ceramic substrate according to claim 1 is manufactured by forming a dot or a continuous groove in a part of at least one side of a sintered substrate with a fiber laser and then, furthermore, forming an auxiliary dot or continuous groove once or more with the fiber laser to form a scribe line.

14. The method for manufacturing a ceramic substrate according to claim 13, wherein the ceramic substrate is manufactured by setting a humidity to 30% or higher and 80% or lower and setting a temperature to 28 degrees Celsius or lower when laser irradiation is performed on the sintered substrate.

15. A method for manufacturing a ceramic split substrate, wherein a ceramic laser-scribed substrate as the ceramic substrate according to claim 1 is manufactured by forming a scribe line with a fiber laser in at least one side of a sintered substrate, then a ceramic split substrate as the ceramic substrate is manufactured by applying stress to the ceramic laser-scribed substrate to split the ceramic laser-scribed substrate.
